# EUROPÄISCHE PATENTSCHRIFT

(11) **EP 0 979 511 B1**
(45) Veröffentlichungstag und Bekanntmachung des Hinweises auf die Patenterteilung: **06.10.2004**
(21) Anmeldenummer: 99903621.3
(22) Anmeldetag: 12.01.1999
(51) Int. Cl.: G11C 27/02

(54) **AUSTASTSCHALTUNG**
BLANKING CIRCUIT
CIRCUIT D'EFFACEMENT

(30) Priorität: 30.01.1998 DE 19803722
(43) Veröffentlichungstag der Anmeldung: 16.02.2000
(73) Patentinhaber: LITEF GmbH, 79115 Freiburg (DE)
(72) Erfinder: RAU, Ernst, D-79189 Bad Krozingen (DE)
(74) Vertreter: Müller - Hoffmann & Partner
(86) Internationale Anmeldenummer: PCT/EP1999/000122
(87) Internationale Veröffentlichungsnummer: WO 1999/039353

(56) Entgegenhaltungen:
- GB-A- 2 108 343
- US-A- 4 404 479
- US-A- 5 479 121

## Beschreibung

Die Erfindung betrifft eine Austastschaltung für in vorgegebener, vorzugsweise periodischer Folge anfallende, kapazitiv zwischenzuspeichernde analoge Signalwerte, die über einen A/D-Wandler digitalisiert und anschließend vor Anfall eines nächsten analogen Signalwerts innerhalb eines durch einen Austastpuls vorgegebenen Zeitintervalls durch Entladung des kapazitiven Speichers zu löschen sind.

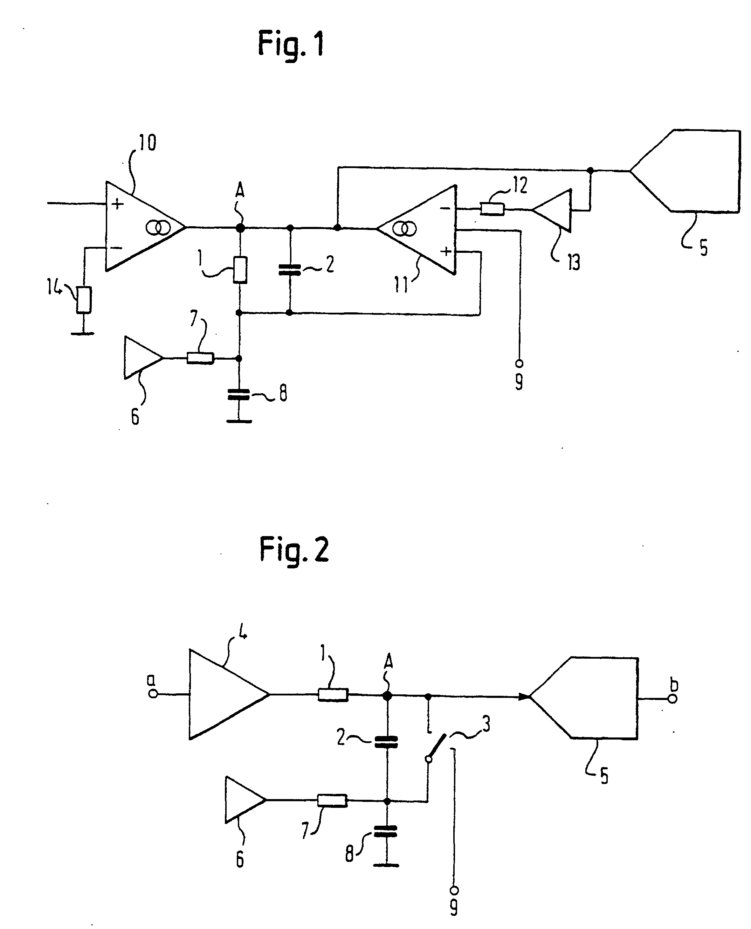

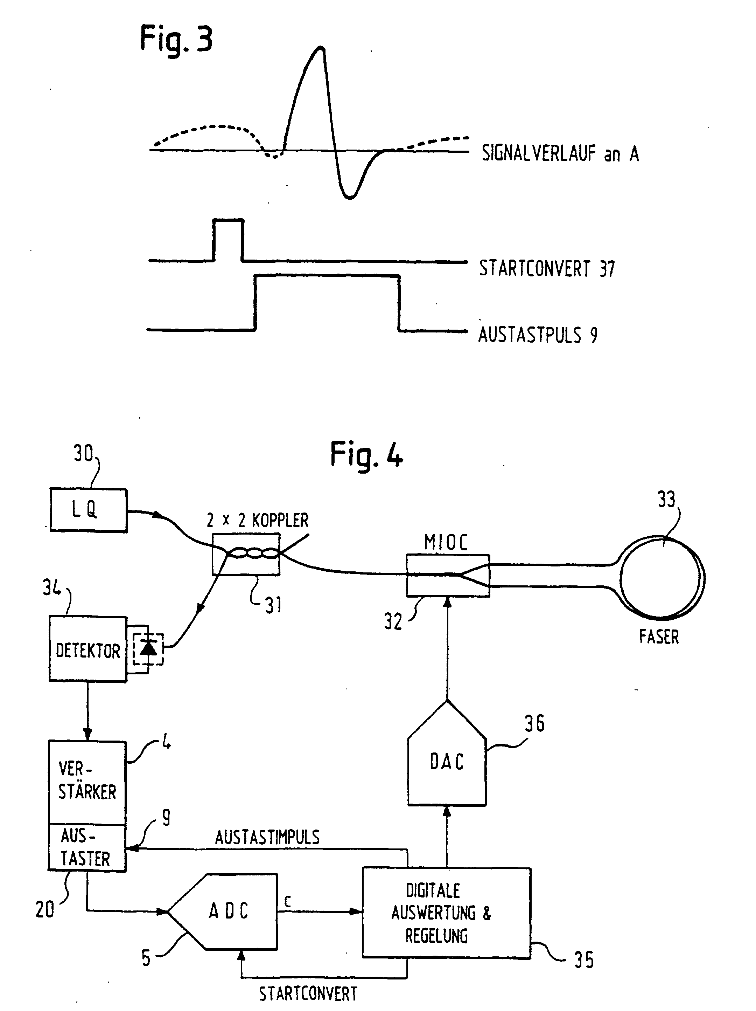

Es gibt eine Vielzahl von Meßwertverarbeitungschaltungen, bei denen ein analoger Meß- oder Signalwert in bestimmter, insbesondere periodischer Folge anfällt, während einer bestimmten Zeitperiode kumulierend gespeichert oder zwischengespeichert wird und dann einer Analog/Digital-Wandlung unterworfen wird, um als Digitalwert weiterverarbeitet zu werden. Ein Meßsystem dieser Art mit offener oder geschlossener Regelschleife ist beispielsweise ein faseroptischer Kreisel (FOG), dessen prinzipieller Aufbau in Fig. 4 der beigefügten Zeichnungen veranschaulicht ist. Das Licht einer Lichtquelle 30 ist über einen Lichtwellenleiter an einen Koppler, beispielsweise einen 2 x 2 Koppler 31 angeschlossen, der in Rückwärtsrichtung über einen weiteren Lichtleiter zu einem lichtempfindlichen Detektor 34 führt. In Vorwärtsrichtung sind an einem Ausgang des Kopplers 31 über einen weiteren, beispielsweise als Raumfilter ausgeführten Lichtleiter ein Polarisator und ein Strahlteiler angeschlossen, die in einem multifunktionalen integrierten optischen Chip MIOC 32 vereinigt sein können, wobei innerhalb dieses MIOC 32 außerdem ein Phasenmodulator mit integriert sein kann. Im Strahlteiler des MIOC 32 wird das ankommende Licht etwa hälftig aufgeteilt, so daß ein an die beiden Ausgänge des MIOC 32 angeschlossener Lichtwellenleiter, insbesondere in Form einer Faserspule, von zwei gegenläufigen Teilwellen durchdrungen wird. Die Teilwellen vereinigen sich nach dem Durchlauf durch die Spule 33 im Strahlteiler des MIOC 32 wieder, laufen dann durch den Polarisator und das erwähnte Raumfilter zum Koppler 31 und gelangen von dort auf den Detektor 34, dessen Ausgangssignal im nachfolgenden Signalverarbeitungsweg zunächst in einem Verstärker 4 verstärkt wird, dann in einem kapazitiven Speicher, der Teil eines Tiefpaßfilters sein kann, kumulierend gespeichert wird, um anschließend als kurzzeitig kumulierter Signalwert über einen A/D-Wandler 5 analog/digital-gewandelt zu werden. Die Digital-Werte vom A/D-Wandler 5 werden einer digitalen Signalauswertung und Regelschaltung 35 zugeführt. die in Zusammenhang mit der vorliegenden Erfindung nicht weiter interessiert. Bei einem FOG mit geschlossener Regelschleife (Closed-Loop-FOG) erfolgt über einen D/A-Wandler 36 eine analoge Rückstellung im MIOC 32. Etwa zeitgleich liefert die digitale Auswerte- und Regelschaltung einen Austastimpuls, auf dessen Funktion im Zusammenhang mit den Fig. 2 und 3 nachfolgend eingegangen wird.

Die Austastung hat bei der soweit anhand der Fig. 4 beschriebenen Meßeinrichtung den Zweck. den während eines Meßzyklus' oder Umlaufs erzeugten Signalwert nach der A/D-Wandlung möglichst glitchfrei, d.h. möglichst ohne die durch den Austastvorgang entstehende Spannungsspitzen zu erzeugen, die im Mittel den Startoder Anfangswert des A/D-Wandlers verschieben können. Dabei ergeben sich Schwierigkeiten, die anhand der Fig. 2. die eine bekannte und bisher verwendete Lösung zeigt, beschrieben werden.

Das Signal aus dem Verstärker 4 gelangt über den aus einem Widerstand 1 und einem Kondensator 2 bestehenden Tiefpaß auf den Eingang des A/D-Wandlers 5. Das obere Signalverlaufsdiagramm der Fig. 3 zeigt im linken Teil den sich am Punkt A aufbauenden Potentialverlauf, dessen kumulierter Signalwert innerhalb eines bestimmten mit STARTKONVERT 37 bezeichneten Zeitschlitzes den Eingang des A/D-Wandlers 5 beaufschlagt. Nach der A/D-Konvertierung wird - bedingt durch einen Austastpuls an 9 - ein den Kondensator 2 überbrückender Schalter 3 geschlossen, wodurch alle Information aus dem betreffenden Umlauf im Kondensator 2 gelöscht wird. Über einen Buffer 6 und ein RC-Glied 7, 8 wird am Fußpunkt des kapazitiven Speichers, also des Kondensators 2 eine für den A/D-Wandler 5 erforderliche Gleichspannung eingestellt.

Die soweit anhand von Fig. 2 beschriebene Schaltung hat ein entscheidendes Problem: Die Amplitude des Austastimpulses am Anschluß 9 muß unter bestimmten Randbedingungen einen erheblichen Wert von beispielsweise bis zu 12 V erreichen. um den Kondensator 2 sicher kurzschließen zu können. Dies widerspricht dem Wunsch einer Versorgung der Schaltung mit nur 5 V. Die Gründe liegen zum einen im geforderten Offset für den A/D-Wandler 5 und in der Höhe der Gate-Spannung für die FETs im Schalter 3 für ein sicheres und niederohmiges Schalten. Aufgrund der Austastung durch den Austastimpuls an 9 zeigt der Signalverlauf am Punkt A Überschwinger, also den erwähnten Glitch, die zum Teil in Abhängigkeit vom jeweils vorhergehenden Signalwert die erwähnte unerwünschte Verschiebung für den Startwert der jeweils nächsten A/D-Wandlung verursachen können. Bipolartransistoren würden ausgelöst durch ihren Basisstrom ein zusätzliches Gleichspannungspotential am Kondensator 2 aufbauen, was den gleichen Effekt bewirkt wie Signalüberschwinger.

Der Erfindung liegt die Aufgabe zugrunde, eine Austastschaltung für den beschriebenen Anwendungsbereich zu schaffen, bei der die sich aus dem Austastvorgang ergebenden Probleme mit Überschwingern bzw. dem Glitch auf die nachfolgende A/D-Wandlung vermeiden lassen und bei der mit den auszutastenden Signalen bis nahe an die Versorgungsspannung herangegangen werden kann, ohne besondere Anforderungen an die Amplitude des Austastimpulses.

Die Erfindung ist bei einer Austastschaltung der im Oberbegriff des Patentanspruchs 1 beschriebenen Art gekennzeichnet durch einen durch den Austastimpuls aktivierbaren ersten OTA (Operational Transconductance Amplifier ≅ funktionsmäßig: spannungsgesteuerte Stromquelle), dessen nicht-invertierender Eingang mit dem Fußpunkt des kapazitiven Speichers und dessen Ausgang mit dem Ladeanschluß des kapazitiven Speichers verbunden ist, während der invertierende Eingang über einen Impedanzwandler und einen Entladestrom-Einstellwiderstand an den Ladeanschluß des kapazitiven Speichers angeschlosssen ist. Der Tiefpaß mit dem kapazitiven Speicherelement wird durch einen Signal-Treiber gespeist, der einen zweiten OTA aufweist, der einen zur Eingangsspannung und zu einem an seinem invertierenden Eingang gegen Bezugspotential geschalteten Widerstand proportionalen Strom in den Tiefpaß einprägt, wobei sein Verstärkungsgrad durch das Verhältnis des zum kapazitiven Speicher des Tiefpasses parallel liegenden Widerstands zu dem das Potential am invertierenden Eingang dieses zweiten OTA bestimmenden Vorwiderstands festgelegt ist.

Ein Ausführungsbeispiel wird nachfolgend unter Bezug auf die Fig. 1 beschrieben. Als Signal-Treiber dient zunächst ein zweiter OTA 10, der einen zur Eingangsspannung an seinem invertierenden Eingang und zu einem auf Bezugspotential geschalteten, am invertierenden Eingang dieses zweiten OTA 10 liegenden Vorwiderstands 14 proportionalen Strom in den ausgangsseitig angeschlossenen Tiefpaß einprägt, bestehend aus der Parallelschaltung eines bereits aus Fig. 2 bekannten Widerstands 1 und eines als kapazitiver kumulierender Speicher dienenden Kondensators 2. Das Verhältnis des Widerstands 1 zum Vorwiderstand 14 bestimmt die aktuelle Verstärkung dieser Signaltreiberstufe. Die sich am Ladeanschluß A, d.h. am Widerstand 1, und am Kondensator 2 aufbauende Spannung wird im A/D-Wandler 5 in ein Digitalsignal konvertiert. Anschließend wird der Kondensator 2 mittels der erfindungsgemäßen Austastschaltung wie folgt entladen:
Der während des Ladevorgangs funktionslose, weil gesperrte erste OTA 11 wird durch den Austastimpuls an 9 aktiviert und treibt solange einen Strom in den Kondensator 2, bis an seinen beiden Anschlüssen gleiches Potential herrscht. Dabei wird der maximale Umladestrom durch einen am Minus-Eingang des ersten OTA 11 liegenden Widerstand und die Ladespannung am Kondensator 2 bestimmt. Durch geeignete Wahl des Widerstands 12 werden eine Anpassung an die Zyklusoder Umlaufzeit und minimale Schaltspitzen bzw. Überschwinger erreicht. Der dem Minus-Eingang am ersten OTA 11 abgekehrte Anschluß des Widerstands 12 ist über einen Impedanzwandler 13 an den Ladeanschluß bzw. an den Eingang des A/D-Wandlers angeschlossen. Die Funktion des Buffers 6 mit RC-Glied 7, 8 ist die gleiche wie oben anhand der bekannten Austastschaltung nach Fig. 2 beschrieben.

Der besondere Vorteil der erfindungsgemäßen Schaltung ist zum einen die Möglichkeit mit den auszutastenden Signalen bis nahezu an den Pegel der Versorgungsspannung heranzugehen, was auch dann noch gilt, wenn auch nur eine einzige Versorgungsquelle vorhanden ist. Zum anderen werden Schaltspitzen, also Überschwinger bzw. Glitch durch einen angepaßten Entladestrom für das jetzt nahezu ideale Tiefpaßfilter erreicht.

## Patentansprüche

1. Austastschaltung für in periodischer Folge anfallende, kapazitiv zwischenzuspeichemde analoge Signalwerte, die über einen A/D-Wandler (5) digitalisiert und anschließend vor Anfall eines nächsten analogen Signalwerts innerhalb eines durch einen Austastimpuls vorgegebenen Zeitintervalls durch Entladung des kapazitiven Speichers zu löschen sind, **gekennzeichnet durch**
- einen **durch** den Austastimpuls (an 9) aktivierbaren ersten OTA (11) (Operational Transconductance Amplifier). dessen nicht-invertierender Eingang (+) mit dem Fußpunkt des kapazitiven Speichers (2) und dessen Ausgang mit dem Ladeanschluß (A) des kapazitiven Speichers (2) verbunden ist, während der invertierende Eingang (-) über einen Impedanzwandler (13) und einen Entladestrom-Einstellwiderstand (12) an den Ladeanschluß (A) des kapazitiven Speichers (2) angeschlossen ist; und
- einen zweiten OTA (10), über den die analogen Signalwerte auf den Ladeanschluß (A) des kapazitiven Speichers (2) gelangen, dessen Verstärkungsgrad **durch** das Verhältnis eines zum kapazitiven Speicher (3) parallel liegenden Widerstands (1) zu einem das Potential am invertierenden Eingang des zweiten OTA (10) bestimmenden Vorwiderstands (14) vorgegeben ist.

## Claims

1. Gating circuit for analogue signal values which are obtained in a periodic sequence, have to be capacitively buffer-stored, are digitized by means of an A/D converter (5) and subsequently have to be erased, before a next analogue signal value is obtained, by discharge of the capacitive store within a time interval which is predetermined by a gating pulse, **characterized by**
- a first OTA (11) (Operational Transconductance Amplifier), which can be activated by the gating pulse (at 9), whose non-inverting input (+) is connected to the reference-earth point of the capacitive store (2) and whose output is connected to the charging terminal (A) of the capacitive store (2), while the inverting input (-) is connected via an impedance converter (13) and a discharge-current variable resistor (12) to the charging terminal (A) of the capacitive store (2); and
- a second OTA (10), via which the analogue signal values pass to the charging terminal (A) of the capacitive store (2), whose gain is predetermined by the ratio of a resistor (1), which is connected in parallel with the capacitive store (2), to a series resistor (14), which determines the potential at the inverting input of the second OTA (10).

## Revendications

1. Circuit d'effacement pour des valeurs de signal analogiques, à mettre en mémoire tampon de manière capacitive, se présentant en séquence périodique, qui doivent être numérisées par l'intermédiaire d'un convertisseur A / N (5) puis supprimées avant l'apparition d'une valeur de signal analogique suivante dans les limites d'un intervalle de temps, prédéterminé par une impulsion d'effacement, par décharge de la mémoire capacitive, **caractérisé par**
- un premier OTA (11) (Operational Transconductance Amplifier), pouvant être activé par l'impulsion d'effacement (en 9), OTA dont l'entrée, non inverseuse (+) est reliée avec la base de la mémoire capacitive (2) et la sortie avec la borne de charge (A) de la mémoire capacitive (2), tandis que l'entrée inverseuse (-) est raccordée, par l'intermédiaire d'un convertisseur d'impédance (13) et d'un rhéostat de réglage de courant de décharge (12), à la borne de charge (A) de la mémoire capacitive (2) et
- un deuxième OTA (10), par l'intermédiaire duquel les valeurs de signal analogiques parviennent à la borne de charge (A) de la mémoire capacitive (2), dont le degré d'amplification est prédéterminé par la relation d'une résistance (1), montée en parallèle par rapport à la mémoire capacitive (3) par rapport à une résistance série (14), qui définit le potentiel à l'entrée inverseuse, du deuxième OTA (10).
